# EUROPÄISCHE PATENTSCHRIFT

(11) **EP 0 383 200 B1**
(45) Veröffentlichungstag und Bekanntmachung des Hinweises auf die Patenterteilung: **06.12.1995**
(21) Anmeldenummer: 90102536.1
(22) Anmeldetag: 09.02.1990
(51) Int. Cl.: G03F 7/40

(54) **Verfahren zur Herstellung von photopolymerisierten Reliefdruckplatten mit klebfreier Oberfäche**
Process for the production of photopolymerised relief-printing plates with non-tacky surface
Procédé pour la fabrication de plaques d'impression en relief photopolymérisées avec surface non collante

(30) Priorität: 17.02.1989 DE 3904780
(43) Veröffentlichungstag der Anmeldung: 22.08.1990
(73) Patentinhaber: BASF Aktiengesellschaft, 67063 Ludwigshafen (DE)
(72) Erfinder: Littmann, Dieter, Dr., D-6800 Mannheim 1 (DE); Koch, Horst, Dr., D-6718 Gruenstadt (DE)

(56) Entgegenhaltungen:
- WO-A-86/02177
- US-A- 2 760 863
- PATENT ABSTRACTS OF JAPAN, vol. 6, no. 125 (P-127)(1003), 10 Juli 1982 & JP-A- 57 52 051

## Beschreibung

Die vorliegende Erfindung betrifft ein neues Verfahren zur Herstellung von Reliefdruckplatten, deren photopolymerisierte Reliefschicht eine klebfreie Oberfläche aufweist, durch
(1) bildmäßiges Belichten einer photopolymerisierbaren reliefbildenden Aufzeichnungsschicht, welche mindestens ein säuregruppenhaltiges polymeres Bindemittel enthält,
(2) Auswaschen (Entwickeln) der unbelichteten und daher nicht photopolymerisierten Bereiche der bildmäßig belichteten reliefbildenden Aufzeichnungsschicht mit einem Entwicklerlösungsmittel und
(3) Nachbehandeln der hierbei resultierenden photopolymerisierten Reliefschicht mit einer Nachbehandlungslösung.

Photopolymerisierbare Reliefdruckplatten, welche in ihrer photopolymerisierbaren reliefbildenden Aufzeichnungsschicht mindestens ein säuregruppenhaltiges polymeres Bindemittel enthalten, sowie Verfahren, hieraus Reliefdruckplatten mit photopolymerisierten Reliefschichten herzustellen, sind aus der DE-A-25 17 043, der DE-B-27 20 228, der DE-A-29 02 412, der DE-A-30 12 841, der US-A-4 415 649, der EP-A-0 076 028, der US-A-4 517 279, der EP-A-0 162 570, der EP-A-0 164 270, der EP-A-0 183 552, der EP-A-0 223 114, der EP-A-0 226 153, der EP-A-0 231 002 oder der EP-A-0 293 750 bekannt.

Desweiteren ist es bekannt, die photopolymerisierten Reliefschichten von Reliefdruckplatten, welche man aus Reliefdruckplatten mit photopolymerisierbaren reliefbildenden Aufzeichnungsschichten der genannten und anderer Art hergestellt hat, zu Zwecken der Klebfreiheit nachzubehandeln. Zum einen kann diese Nachbehandlung mit Hilfe Halogene enthaltender oder Halogene freisetzender Nachbehandlungslösungen (vgl. die EP-B-0 021 829, die US-A-4 2 67 214, die DE-A-28 23 300, die US-A-4 400 459, die EP-A-0 064 564, die EP-A-0 096 835, die EP-A-0 208 943 oder die EP-A-0 256 309) oder mit Hilfe von kurzwelligem UV-Licht (vgl. die US-A-3 506 440, die US-A-4 415 654, die US-A-4 202 696, die EP-B-0 017 927 oder die EP-A-0 154 994) erfolgen.

Die bislang bekannten Nachbehandlungsverfahren weisen indes Nachteile auf. So erfordert die Nachbehandlung mit kurzwelligem UV-Licht naturgemäß aus sicherheitstechnischen Gründen einen erhöhten apparativen Aufwand, u.a. auch deswegen, weil bei der Bestrahlung der photopolymerisierten Reliefschichten der Reliefdruckplatten aus dem Sauerstoff der sie umgebenden Luft das hochgiftige Ozon entsteht, welches zudem noch die photopolymerisierten Reliefschichten selbst schädigt. Diese Schädigung kann nur dadurch vermieden werden, daß man die Nachbelichtung der photopolymerisierten Reliefschichten unter Stickstoff, unter Wasser oder unter einer wäßrigen Alkali- oder Erdalkalisulfitlösung durchführt, was indes den apparativen Aufwand weiter erhöht. Hinzu kommt noch, daß die Nachbehandlung mit Hilfe von kurzwelligem UV-Licht die Oberfläche photopolymerisierter Reliefschichten der eingangs genannten Art entweder nicht völlig klebfrei macht oder sie versprödet.

Vom Umweltschutz, von der Arbeitshygiene und von der Praktikabilität hergesehen, sind die korrosiven halogenhaltigen oder Halogene freisetzenden Nachbehandlungslösungen von Nachteil. So können die Komponenten dieser Nachbehandlungslösungen nicht vorgemischt dem Endverbraucher zugehen, sondern dieser muß sie unmittelbar vor der Anwendung selbst in den richtigen Mengenverhältnissen zusammengeben, wofür indes beim Endverbraucher, dem Reprographen, allein schon aus sicherheitstechnischen Gründen gewisse chemische Kenntnisse vorausgesetzt werden müssen, die für ihn fachfremd sind. Außerdem müssen die für die Nachbehandlung notwendigen Zeiten sehr genau eingehalten werden, da ansonsten die nachbehandelten Oberflächen der photopolymerisierten Reliefschichten verspröden und zur Rißbildung neigen. Außerdem sind diese Nachbehandlungslösungen meist recht instabil und besitzen nur eine geringe Standzeit. Versäumt man den richtigen Zeitpunkt ihrer Anwendung, erhält man in nicht vorhersagbarer Weise nicht praxisgerechte Nachbehandlungsresultate. Darüber hinaus können sich auf den solchermaßen nachbehandelten Oberflächen beim Wegwaschen der Halogenreste Tropfenspuren bilden, welche sich beim Drucken im Druckergebnis unangenehm bemerkbar machen. Zudem werden photopolymerisierte Reliefschichten, deren Oberfläche solche Tropfenspuren aufweist, während des Druckens bei höheren Druckauflagen wieder klebrig.

Weil aber eine zu hohe Oberflächenklebrigkeit der photopolymerisierten Reliefschichten von Reliefdruckplatten, insbesondere von flexographischen Reliefdruckplatten, beim Drucken zum Rupfen und Reißen der Papierbahnen führt, wobei außerdem noch feine Bildelemente durch herausgerupfte Papierfasern zugeschmiert werden, besteht noch immer ein Bedarf an Nachbehandlungsmethoden, durch welche dieses drucktechnische Problem beseitigt oder zumindest gemildert wird. Da aber die bislang bekannten Nachbehandlungsverfahren selbst schwerwiegende Nachteile aufweisen, ergibt sich der Zwang nach neuen Wegen zur Lösung des Problems zu suchen.

Es ist daher die Aufgabe der vorliegenden Erfindung, eine neues Verfahren zu finden, welches der Herstellung einer Reliefdruckplatte dient, deren photopolymerisierte Reliefschicht eine klebfreie Oberfläche aufweist, wobei das neue Verfahren die vorstehend geschilderten Nachteile des Standes der Technik nicht mehr länger aufweisen soll.

Überraschenderweise konnte diese Aufgabe bei den Reliefdruckplatten mit photopolymerisierten Reliefschichten der eingangs genannten Art durch das Nachbehandeln der photopolymerisierten Reliefschicht mit einer basischen Nachbehandlungslösung elegant gelöst werden.

Demnach handelt es sich bei dem Gegenstand der vorliegenden Erfindung um ein Verfahren zur Herstellung einer Reliefdruckplatte, deren photopolymerisierte Reliefschicht eine klebfreie Oberfläche aufweist, durch
(1) bildmäßiges Belichten einer photopolymerisierbaren reliefbildenden Aufzeichnungsschicht (A), welche
   a₁) mindestens ein säuregruppenhaltiges polymeres Bindemittel,
   a₂) mindestens ein olefinisch ungesättigtes photopolymerisierbares Monomeres, welches mit dem säuregruppenhaltigen polymeren Bindemittel (a₁) verträglich ist, und
   a₃) mindestens einen Photopolymerisationsinitiator enthält,
(2) Auswaschen (Entwickeln) der unbelichteten und daher nicht photopolymerisierten Bereiche der bildmäßig belichteten reliefbildenden Aufzeichnungsschicht (A) mit einem Entwicklerlösungsmittel und
(3) Nachbehandeln der hierbei resultierenden photopolymerisierten Reliefschicht mit einer Nachbehandlungslösung,

wobei das Verfahren dadurch gekennzeichnet ist, daß man bei dem Verfahrensschritt (3) eine basische Nachbehandlungslösung verwendet, die als Basen Metallhydroxide und/oder basisch reagierende Metallsalze enthält.

Im folgenden wird das neue Verfahren zur Herstellung einer Reliefdruckplatte, deren photopolymerisierte Reliefschicht eine klebfreie Oberfläche aufweist, der Kürze halber als "erfindungsgemäßes Verfahren" bezeichnet.

Der erfindungsgemäß wesentliche Verfahrensschritt des erfindungsgemäßen Verfahrens ist der Verfahrensschritt (3). Hierbei handelt es sich um das Nachbehandeln der aus den Verfahrensschritten (1) und (2) des erfindungsgemäßen Verfahrens resultierenden photopolymerisierten Reliefschicht mit einer Nachbehandlungslösung. Erfindungsgemäß wird hierbei eine basische Nachbehandlungslösung verwendet, die als Basen Metallhydroxide und/oder basisch reagierende Metallsalze enthält.

Die erfindungsgemäß zu verwendende Nachbehandlungslösung enthält vorzugsweise mindestens ein Lösungsmittel und mindestens ein Metallhydroxid und/oder basisch reagierendes Metallsalz.

Als Lösungsmittel kommen sowohl aprotisch polare als auch protisch polare Lösungsmittel sowie Gemische aus aprotisch und protisch polaren Lösungsmitteln in Betracht.

Beispiele gut geeigneter aprotisch polarer Lösungsmittel sind Di-n-Butylether, Tetrahydrofuran, Dioxan, Aceton, Methylethylketon, Acetylaceton, Essigsäureethylester, Acetonitril und Methylpyrrolidon.

Beispiele geeigneter protisch polarer Lösungsmittel sind Wasser, Methanol, Ethanol, n-Propanol, Isopropanol, n-Butanol, Essigsäure, Ethylenglykol, Diethylenglykol oder Diethylenglykolmonomethylether.

Beispiele gut geeigneter Lösungsmittel sind Wasser, Glykol, n-Butanol oder Diethylenglykol, von denen Wasser ganz besonders bevorzugt verwendet wird.

Beispiele geeigneter erfindungsgemäß zu verwendender Basen sind Metallhydroxide und basisch reagierende Metallsalze.

Beispiele gut geeigneter Metallhydroxide sind die Alkali-, Erdalkali-, Scandium-, Yttrium-, Lanthan- und die Lanthanidhydroxide, von denen Natrium-, Kalium-, Kalzium-, Strontium- und Bariumhydroxid besonders gut geeignet sind. Von diesen wiederum ist Natriumhydroxid ganz besonders gut geeignet.

Beispiele gut geeigneter erfindungsgemäp zu verwendender basisch reagierender Metallsalze sind basisch reagierende Alkali-, Erdalkali-, Scandium-, Yttrium-, Lanthan- und Lanthanidsalze, von denen die Natrium-und Kaliumsalze besonders gut und die Natriumsalze ganz besonders gut geeignet sind.

Weitere Beispiele für gut geeignete erfindungsgemäß zu verwendende basisch reagierende Salze sind Carbonate, Phosphate, Borate, Carboxylate, Alkoxide und Phenoxide, von denen die Alkali-, Erdalkali-, Scandium-, Yttrium-, Lanthan- und Lanthanidcarbonate, -phosphate, -borate, -carboxylate, -alkoxide und -phenoxide besonders gut geeignet sind.

Beispiele besonders gut geeigneter erfindungsgemäß zu verwendender basisch reagierender Salze sind Natriumacetat, Natriumpropionat, Natriumcarbonat, Kaliumcarbonat, Natriumborat, Natriummethylat und Natriumethylat, von denen Natriumcarbonat ganz besonder bevorzugt verwendet wird.

Die Basen sind in den erfindungsgemäß zu verwendenden Nachbehandlungslösungen in einer Menge von 0,05 bis 10, vorteilhafterweise 0,01 bis 5 und insbesondere 0,05 bis 2,5 Gew.-%, bezogen auf die jeweilige Nachbehandlungslösung, enthalten. Hierbei richtet sich die Menge der Base oder Basen in der jeweils verwendeten Nachbehandlungslösung zum einen nach der Beschaffenheit und der stofflichen Zusammensetzung der nachzubehandelnden Oberfläche der photopolymerisierten Reliefschicht und zum anderen nach der Löslichkeit der betreffenden Base oder Basen in den jeweils verwendeten Lösungsmitteln. Deshalb kann die jeweils zu verwendende Zusammensetzung der Nachbehandlungslösung vom Fachmann anhand einfacher Vorversuche ermittelt werden.

Neben den vorstehend beschriebenen Lösungsmitteln und Basen kann die erfindungsgemäß zu verwendende Nachbehandlungslösung Tenside in einer Menge von 0,001 bis 1 Gew.-%, bezogen auf die betreffende Nachbehandlungslösung, enthalten. Grundsätzlich kommen hierfür alle Tenside in Betracht, welche sich in der Gegenwart der vorstehend genannten Basen nicht zersetzen und in dem jeweils verwendeten Lösungsmittel löslich sind. Beispiele geeigneter Tenside sind die kationischen und anionischen Amphiphile, die eine gesättigte Kohlenwasserstoffkette mit 8 bis 20 Kohlenstoffatomen oder eine oder mehrere perfluorierte Kohlenstoffketten mit 5 bis 18 Kohlenstoffatomen aufweisen, Ethylenoxid-Propylenoxid-Blockmischpolymerisate und Alkylglucoside. Beispiele gut geeigneter Tenside gehen aus der EP-A-0 208 943 hervor.

Methodisch bietet die für die Erfindung wesentliche Nachbehandlung der Oberfläche photopolymerisierter Reliefschichten (Verfahrensschritt 3) keine Besonderheiten, sondern sie wird im Rahmen des erfindungsgemäßen Verfahrens nach der bildmäßigen Belichtung der photopolymerisierbaren reliefbildenden Aufzeichnungsschicht (A) der photopolymerisierbaren Reliefdruckplatte (Verfahrensschritt 1) und dem Auswaschen (Entwickeln) der unbelichteten und daher nicht photopolymerisierten Bereiche der bildmäßig belichteten reliefbildenden Aufzeichnungsschicht (A) mit einem Entwicklerlösungsmittel (Verfahrensschritt 2) durchgeführt. Hierbei kann man die in dieser Weise erzeugte photopolymerisierte Reliefschicht im Verfahrensschritt (3) mit der erfindungsgemäß zu verwendenden Nachbehandlungslösung besprühen, oder man kann die photopolymerisierten Reliefschichten bzw. die Reliefdruckplatten in ein Nachbehandlungsbad eintauchen, welches die erfindungsgemäß zu verwendende Nachbehandlungslösung enthält. Unabhängig davon, welche Methode für die Nachbehandlung verwendet wird, liegt die Kontaktzeit der jeweils nachbehandelten Oberfläche einer photopolymerisierten Reliefschicht mit der Nachbehandlungslösung bei 10 s bis 15 min, vorzugsweise bei 30 s bis 5 min und insbesondere bei 1 bis 3 min.

Das erfindungsgemäße Verfahren wird mit Reliefdruckplatten durchgeführt, welche eine an sich bekannte photopolymerisierbare reliefbildende Aufzeichnungsschicht (A) enthalten. Diese an sich bekannte photopolymerisierbare reliefbildende Aufzeichnungsschicht (A) enthält wiederum mindestens ein säuregruppenhaltiges polymeres Bindemittel (a₁), mindestens ein olefinisch ungesättigtes photopolymerisierbares Monomeres (a₂), welches mit dem Bindemittel (a₁) verträglich ist, und mindestens einen Photopolymerisationsinitiator (a₃). Beispiele von Reliefdruckplatten mit geeigneten photopolymerisierbaren reliefbildenden Aufzeichnungsschichten (A) der genannten Art werden in der DE-A-25 17 043, der DE-B-27 20 228, der DE-A-29 02 412, der DE-A-30 12 841, der US-A-4 415 649, der EP-A-0 076 028, der US-A-4 517 279, der EP-A-0 162 570, der EP-A-0 164 270, der EP-A-0 183 552, der EP-A-0 223 114, der EP-A-0 226 153, der EP-A-0 231 002 und der EP-A-0 293 750 beschrieben.

Besonders bevorzugt verwendet werden die photopolymerisierbaren reliefbildenden Aufzeichnungsschichten (A) der EP-A-0 223 114, der EP-A-0 231 002 oder der EP-A-0 293 750, welche modifizierte oder unmodifizierte Copolymerisate des Ethylens mit (Meth)acrylsäure und mindestens einem Vinylester, Vinylether, (Meth)Acrylsäureester und/oder (Meth)Acrylsäureamid als säuregruppen- bzw. carboxylgruppenhaltige polymere Bindemittel (a₁) enthalten, oder der EP-A-0 226 153, welche maleinierte und teilveresterte oder teilamidierte Polybutadiene als säuregruppen- bzw. carboxylgruppenhaltige polymere Bindemittel (a₁) enthalten.

Bekanntermaßen enthalten diese photopolymerisierbaren reliefbildenden Aufzeichnungsschichten (A) außer den vorstehend genannten säuregruppenhaltigen polymeren Bindemitteln (a₁) stets auch noch hiermit verträgliche, olefinisch ungesättigte photopolymerisierbare Monomere (a₂) sowie die zur Initiierung der Photopolymerisation notwendigen Photopolymerisationsinitiatoren (a₃) in den üblichen Mengen. Darüber hinaus können die photopolymerisierbaren reliefbildenden Aufzeichnungsschichten (A) weitere Zusatzstoffe wie Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Füllmittel und/oder Verstärkerfüllstoffe in wirksamen Mengen enthalten.

Im Rahmen des erfindungsgemäßen Verfahrens werden diese an sich bekannten photopolymerisierbaren reliefbildenden Aufzeichnungsschichten (A) in üblicher Weise mit aktinischem Licht bildmäßig belichtet (Verfahrensschritt 1). Beispiele geeigneter Lichtquellen für aktinisches Licht sind die üblichen und bekannten Quecksilberhoch-, -mittel- oder -niederdruckstrahler, UV-Fluoreszenzröhren und mit Metallhalogeniden dotierte Lampen.

Hiernach werden die unbelichteten und daher nicht photopolymerisierten Bereiche der bildmäßig belichteten reliefbildenden Aufzeichnungsschicht (A) mit einem Entwicklerlösungsmittel ausgewaschen bzw. entwickelt (Verfahrensschritt 2). Bekanntermaßen wird die Entwicklung in den üblichen und bekannten Sprüh-, Reibe- und Bürstenwascher durchgeführt. Beispiele geeigneter Entwicklerflüssigkeiten sind die vorstehend beschriebenen aprotisch polaren und protisch polaren Lösungsmittel.

Das erfindungsgemäße Verfahren kann neben den Verfahrensschritten (1) und (2) sowie dem für die Erfindung wesentlichen Verfahrensschritt (3) noch weitere an sich bekannte Verfahrensschritte umfassen.

Beispiele geeigneter weiterer an sich bekannter Verfahrensschritte sind das vollflächige Vorbelichten der photopolymerisierbaren reliefbildenden Aufzeichnungsschicht (A) der Reliefdruckplatte, Trocknungsschritte, welche sich den Verfahrensschritten (2) und (3) anschließen, sowie das vollflächige Nachbelichten der in erfindungsgemäßer Weise hergestellten photopolymerisierten Reliefschicht.

Das erfindungsgemäße Verfahren weist gegenüber dem Stand der Technik zahlreiche Vorteile auf. So haben die in erfindungsgemäßer Weise hergestellten Reliefdruckplatten eine photopolymerisierte Reliefschicht, deren Oberfläche klebfrei ist. Diese Reliefdruckplatten eignen sich deshalb vorzüglich für den Flach-, Hoch- und Flexodruck, wobei sie außerdem noch als Photoresiste verwendet werden können. Vorzugsweise werden sie für den Flexodruck, insbesondere beim Endlosdruck, verwendet. Außerdem können die Komponenten der erfindungsgemäß zu verwendenden Nachbehandlungslösungen dem Reprographen bereits als fertige, leicht dosierbare, unbegrenzt lagerfähige Mischung geliefert werden, wobei im allgemeinen für die Herstellung, Handhabung und Entsorgung der Nachbehandlungslösungen keine umfangreichen technischen Sicherheitsmaßnahmen notwendig werden und beim Anwender keine besonderen chemischen Kenntnisse vorausgesetzt werden müssen. Außerdem müssen die durch Vorversuche ermittelten optimalen Nachbehandlungszeiten nicht streng eingehalten werden, um Schädigungen der Oberfläche der photopolymerisierten Reliefschichten zu vermeiden, sondern sie können, wenn der betriebliche Ablauf dies erfordert, ohne weiteres überschritten werden, was der Koordination von Arbeitsgängen in einem reprographischen Betrieb erheblich mehr Spielraum läßt. Ein zusätzlicher Vorteil ist, daß die erfindungsgemäß anzuwendenden Nachbehandlungslösungen länger haltbar sind und selbst nach längerer Standzeit und/oder mehrmaligem Gebrauch sehr leicht regeneriert werden können, ohne daß dies zu nachteiligen Ergebnissen führt. Darüber hinaus wirken sie weniger korrosiv als die bekannten Nachbehandlungslösungen. Zusätzlich verbessert der erfindungsgemäß durchzuführende Nachbehandlungsschritt die Oberfläche der photopolymerisierten Reliefschicht nicht nur hinsichtlich ihrer Klebrigkeit, sondern auch hinsichtlich der Gleichmäßigkeit ihrer Mattheit und ihrer optischen Homogenität sowie hinsichtlich ihrer Stabilität gegenüber Versprödung und Rißbildung bei längerer Lagerung und/oder Dauergebrauch. Die in erfindungsgemäßer Verfahrensweise hergestellten Reliefdruckplatten können deshalb erheblich öfter und länger im Flexodruck verwendet werden als Reliefdruckplatten, welche man nach Verfahren des Standes der Technik hergestellt hat. Die in erfindungsgemäßer Weise hergestellten Reliefdruckplatten liefern demnach eine sehr viel höhere Auflage an ausgezeichneten Drucken. Hinzu kommt noch, daß die klebfreie Oberfläche ihrer photopolymerisierten Reliefschichten eine vorzügliche Farbannahme aufweist, dabei aber gegenüber den Druckfarbenlösungsmitteln ausgesprochen stabil ist und von diesen nicht in einem störenden Ausmaß angequollen wird.

### Beispiele und Vergleichsversuche

In den folgenden Beispielen und Vergleichsversuchen wurde die Klebrigkeit der Oberfläche der photopolymerisierten Reliefschichten entweder über die Meßung der Pendelklebrigkeit nach DIN 53 157 oder mit Hilfe des Tastsinns bestimmt. Die mit Hilfe des Tastsinns ermittelte Klebrigkeit wurde wie folgt benotet:
Note 1 - nicht klebrig;
Note 2 - schwach klebrig;
Note 3 - stark klebrig.

### Beispiele 1 bis 5 und Vergleichsversuch V1

### Versuchsvorschrift:

Für die Beispiele 1 bis 5 und den Vergleichsversuch V1 wurden 6 Reliefdruckplatten stofflich gleicher Zusammensetzung und gleichen Aufbaus wie folgt hergestellt:

Ein 0,24 mm dickes Stahlblech, wie es üblicherweise als Trägerblech für Reliefdruckplatten verwendet wird, wurde mit einer üblichen und bekannten, ca. 15 »m starken Grundierschicht sowie mit einer üblichen und bekannten ca. 5 »m starken Haftlackschicht versehen. Hiernach wurde auf die Haftlackschicht die 500 »m dicke photopolymerisierbare reliefbildende Aufzeichnungsschicht (A) auflaminiert. Die photopolymerisierbare reliefbildende Aufzeichnungsschicht (A) selbst bestand aus 63,6 Gew.-% eines Copolymerisats aus, bezogen auf das Copolymerisat, 60 Gew.-% Butadien, 20 Gew.-% Acrylsäure und 20 Gew.-% n-Butylacrylat eines Schmelzflußindices (mfi) von 300 g/10 min (gemessen bei 190°C und einer Auflagekraft von 21 N) (säuregruppenhaltiges polymeres Bindemittel a₁), 11,9 Gew.-% Hexan-1,6-diol-diacrylat (Monomeres a₂), 7,9 Gew.-% N-n-Propyl-N-(2-hydroxyethyl)amin, 3,95 Gew.-% Glycidylmethacrylat (Monomeres a₂), 1,5 Gew.-% Benzildimethylacetal (Photopolymerisationsinitiator a₃), 3,17 Gew.-% Hydrochinonmonomethylether und 7,98 Gew.-% N-n-Butylbenzolsulfonamid.

Die 6 Reliefdruckplatten wurden 5 Tage bei Raumtemperatur gelagert und hiernach wie folgt weiter verarbeitet:

### Beispiel 1

Eine der vorstehend beschriebenen 6 Reliefdruckplatten wurde in üblicher und bekannter Weise in einem Flachbelichter bildmäßig belichtet und hiernach mit reinem Wasser entwickelt. Die in dieser Weise erhaltene Reliefdruckplatte mit einer photopolymerisierten Reliefschicht wurde zunächst getrocknet und anschließend während 3 min mit einem Flachbelichter (Lichtleistung 40 Watt) nachbelichtet. Im Anschluß an die Nachbelichtung wurde die Reliefdruckplatte 30 s lang in eine 2 %ige Natriumcarbonatlösung eingetaucht und hiernach getrocknet. Die Oberfläche ihrer photopolymerisierten Reliefschicht war praktisch klebfrei (Pendelklebrigkeit nach DIN 53 157: 7).

### Beispiel 2

Beispiel 1 wurde wiederholt, nur daß die Nachbehandlungszeit (Tauchzeit) bei 1 min lag. Hiernach wies die photopolymerisierte Reliefschicht der Reliefdruckplatte eine klebfreie Oberfläche auf (Pendelklebrigkeit nach DIN 53 157: 10).

### Beispiel 3

Beispiel 1 wurde wiederholt, nur wurde die Reliefdruckplatte 30 s lang in 1 %ige Natronlauge eingetaucht Die Oberfläche der photopolymerisierten Reliefschicht war hiernach völlig klebfrei (Pendelklebrigkeit nach DIN 53 157: 32).

### Beispiel 4

Beispiel 3 wurde wiederholt, nur lag die Nachbehandlungszeit (Tauchzeit) bei 1 min. Die Oberfläche der photopolymerisierten Reliefschicht war völlig klebfrei (Pendelklebrigkeit nach DIN 53 157: 43).

### Beispiel 5

Beispiel 4 wurde wiederholt, mit dem Unterschied, daß anstelle der 1 %igen Natronlauge eine Lösung aus 0,5 Gew.-% Natronlauge, 0,1 Gew.-% eines Tensids (Natriumparaffinsulfonat) und 99,4 Gew.-% Wasser verwendet wurde. Die in dieser Weise nachbehandelte photopolymerisierte Reliefschicht war sowohl an der Reliefoberfläche als auch im Reliefgrund völlig klebfrei.

Die Reliefdruckplatte wurde auf einen Druckzylinder aufgespannt und in einem üblichen und bekannten Flexodruckwerk unter Verwendung ethanolhaltiger Flexodruckfarben für den Flexoendlosdruck verwendet. Hierbei wurden hervorragende Druckergebnisse erhalten, wobei die Qualität der Drucke selbst nach einer Auflage von 100.000 Stück unverändert blieb.

### Vergleichsversuch V1

Beispiel 5 wurde wiederholt, mit dem Unterschied, daß die erfindungsgemäß anzuwendende Nachbehandlung der Reliefdruckplatte unterblieb. Die Oberfläche der photopolymerisierten Reliefschicht der Reliefdruckplatte wies deshalb eine hohe Klebrigkeit auf (Pendelklebrigkeit nach DIN 53 157: 2). Beim Flexoendlosdruck wurden daher auch keine sauberen Druckerzeugnisse erhalten; außerdem war die Auflage, bedingt durch die deutlich schlechtere Haltbarkeit der Reliefdruckplatte unter Druckbedingungen, niedrig.

### Beispiel 6 und Vergleichsversuch V2

Für die Durchführung des Beispiel 6 und des Vergleichsversuchs V2 wurde ein photopolymerisierbares Gemisch durch Extrusion von 7,82 kg eines Copolymerisats aus, bezogen auf das Copolymerisat, 57,1 Gew.-% Ethylen, 18,9 Gew.-% Acrylsäure und 24 Gew.-% 2-Ethylhexyl-acrylat (säuregruppenhaltiges polymeres Bindemittel a₁), 500 g Glycidylmethacrylat (Monomeres a₂), 500 g Methylmethacrylat (Monomeres a₂), 100 g Benzildimethylacetal (Photopolymerisationsinitiator a₃), 2,5 g N-Methylimidazol, 25 g 2,6-Di-tert.-butyl-p-kresol, 750 g N-n-Butylbenzolsulfonamid, 40 g N-Nitrosocyclohexylhydroxylamin-Kaliumsalz und 3 g Safranin T (C.I. 50240) hergestellt. Das photopolymerisierbare Gemisch wurde aus dem Extruder ausgetragen und in einem Kalander zu der photopolymerisierbaren reliefbildenden Aufzeichnungsschicht (A) einer Dicke von 2675 »m geformt. Gleichzeitig mit ihrer Abformung wurde die photopolymerisierbare reliefbildende Aufzeichnungsschicht (A) auf ihrer einen Seite mit einer Polyethylenterephthalat-Trägerfolie, welche mit einer üblichen und bekannten Haftlackschicht versehen war, und auf ihrer anderen Seite mit einer Polyethylenterephthalat-Deckfolie, welche mit einer aus einem Polyvinylalkohol bestehenden Deckschicht bedeckt war, haftfest zu einer Reliefdruckplatte einer Gesamtdicke von 3000 »m verbunden.

Die in dieser Weise erhaltene Reliefdruckplatte wurde während 60 s von ihrer Rückseite her mit aktinischem Licht vorbelichtet. Hiernach wurde die Polyethylenterephthalat-Deckfolie entfernt, und es wurde auf die Oberfläche der an der photopolymerisierbaren reliefbildenden Aufzeichnungsschicht (A) fest haftenden Polyvinylalkohol-Deckschicht ein Standardnegativ aufgelegt. Danach wurde die photopolymerisierbare reliefbildende Aufzeichnungsschicht (A) durch das Standardnegativ hindurch während 20 min bildmäßig mit einem Röhrenflachbelichter belichtet. Im Anschluß an die bildmäßige Belichtung wurden die unbelichteten und daher nicht photopolymerisierten Bereiche der bildmäßig belichteten reliefbildenden Aufzeichnungsschicht (A) während 30 s in einem Sprühwascher mit reinem Wasser und hiernach während 5 min in einem Bürstenrundwascher mit einem Gemisch aus Perchlorethylen und n-Butanol im Volumenverhältnis von 4 : 2 ausgewaschen. Die in dieser Weise erhaltene Reliefdruckplatte mit einer photopolymerisierten Reliefschicht wurde 60 min lang bei 60°C getrocknet und im Anschluß an die Trocknung während 20 min mit einem Röhrenflachbelichter nachbelichtet. Danach wurde die Reliefdruckplatte in zwei Hälften geteilt. Die eine Hälfte wurde für die Durchführung des Beispiels 6, die andere Hälfte für die Durchführung des Vergleichsversuchs V2 verwendet.

### Vergleichsversuch V2

Die hierfür verwendete Hälfte der Reliefdruckplatte wurde nicht weiter nachbehandelt. Demgemäß wies die Oberfläche ihrer photopolymerisierbaren reliefbildenden Aufzeichnungsschicht (A) eine ausgesprochen hohe Klebrigkeit auf (Ermittlung mit dem Tastsinn, Note 3). Nach dem Aufspannen dieser nicht weiter nachbehandelten Hälfte der Reliefdruckplatte wurde sie in einem üblichen und bekannten Flexodruckwerk für den Flexoendlosdruck mit ethanolhaltigen Flexodruckfarben verwendet. Hierbei konnten keine einwandfreien Druckerzeugnisse erhalten werden. Außerdem war die Auflage, bedingt durch die deutlich schlechtere Haltbarkeit der nicht weiter nachbehandelten photopolymerisierten Reliefschicht, niedrig.

### Beispiel 6

Die andere Hälfte der Reliefdruckplatte wurde dem im Beispiel 5 beschriebenen Nachbehandlungsverfahren unterzogen, mit dem Resultat, daß die photopolymerisierte Reliefschicht nun eine völlig klebfreie Oberfläche aufwies (Ermittlung durch den Tastsinn, Note 1). Bei der Verwendung dieser in erfindungsgemäßer Weise nachbehandelten Hälfte der Reliefdruckplatte für den Flexoendlosdruck mit ethanolhaltigen Flexodruckfarben wurden ausgezeichnete Druckerzeugnisse in einer Auflagenhöhe von weit über 100.000 Stück erhalten.

## Patentansprüche

1. Verfahren zur Herstellung einer Reliefdruckplatte, deren photopolymerisierte Reliefschicht eine klebfreie Oberfläche aufweist, durch
(1) bildmäßiges Belichten einer photopolymerisierbaren reliefbildenden Aufzeichnungsschicht (A), welche
a₁) mindestens ein säuregruppenhaltiges polymeres Bindemittel,
a₂) mindestens ein olefinisch ungesättigtes photopolymerisierbares Monomeres, das mit dem säuregruppenhaltigen polymeren Bindemittel (a₁) verträglich ist, und
a₃) mindestens einen Photopolymerisationsinitiator enthält,
(2) Auswaschen (Entwickeln) der unbelichteten und daher nicht photopolymerisierten Bereiche der bildmäßig belichteten reliefbildenden Aufzeichnungsschicht (A) mit einem Entwicklerlösungsmittel und
(3) Nachbehandeln der hierbei resultierenden photopolymerisierten Reliefschicht mit einer Nachbehandlungslösung,
dadurch gekennzeichnet, daß man bei dem Verfahrensschritt (3) eine basische Nachbehandlungslösung verwendet, die als Basen Metallhydroxide und/oder basisch reagierende Metallsalze enthält.

2. Das Verfahren nach Anspruch 1, dadurch gekennzeichnet, daß das säuregruppenhaltige polymere Bindemittel (a₁) Carboxylgruppen enthält.

3. Das Verfahren nach Anspruch 1 oder 2, dadurch gekennzeichnet, daß die Nachbehandlungslösung mindestens ein Lösungsmittel und mindestens ein Metallhydroxid und/oder basisch reagierendes Metallsalz enthält.

4. Das Verfahren nach einem der Ansprüche 1 bis 3, dadurch gekennzeichnet, daß die Nachbehandlungslösung mindestens ein Tensid enthält.

5. Das Verfahren nach Anspruch 3 oder 4, dadurch gekennzeichnet, daß man aprotisch polare und/oder protisch polare Lösungsmittel verwendet.

6. Das Verfahren nach einem der Ansprüche 1 bis 5, dadurch gekennzeichnet, daß man Alkali-, Erdalkali-, Scandium-, Yttrium-, Lanthan- und/oder Lanthanidhydroxide und/oder basisch reagierende Alkali-, Erdalkali-, Scandium-, Yttrium-, Lanthan- und/oder Lanthanidsalze verwendet.

7. Das Verfahren nach einem der Ansprüche 1 bis 6, dadurch gekennzeichnet, daß man als basisch reagierende Salze Carbonate, Phosphate, Borate, Carboxylate, Alkoxide und/oder Phenoxide verwendet, welche in den aprotisch polaren und/oder protisch polaren Lösungsmitteln löslich sind.

## Claims

1. A process for the production of a relief printing plate whose photopolymerized relief layer has a non-tacky surface, by
(1) imagewise exposure of a photopolymerizable relief-forming recording layer (A), which contains
a₁) one or more polymeric binders containing acid groups,
a₂) one or more olefinically unsaturated photopolymerizable monomers which are compatible with the polymeric binders (a1) containing acid groups and
a₃) one or more photopolymerization initiators,
(2) washing out (development) of the unexposed and therefore non-photopolymerized parts of the imagewise exposed relief-forming recording layer (A) with a developer and
(3) aftertreatment of the resulting photopolymerized relief layer with an aftertreatment solution,
wherein a basic aftertreatment solution containing metal hydroxides and/or basic metal salts as bases is used in process step (3).

2. A process as claimed in claim 1, wherein the polymeric binder (a1) containing acid groups contains carboxyl groups.

3. A process as claimed in claim 1 or 2, wherein the aftertreatment solution contains one or more solvents and one or more metal hydroxides and/or basic metal salts.

4. A process as claimed in any of claims 1 to 3, wherein the aftertreatment solution contains one or more surfactants.

5. A process as claimed in claim 3 or 4, wherein aprotic polar and/or protic polar solvents are used.

6. A process as claimed in any of claims 1 to 5, wherein alkali metal, alkaline earth metal, scandium, yttrium, lanthanum and/or lanthanide hydroxides and/or basic alkali metal, alkaline earth metal, scandium, yttrium, lanthanum and/or lanthanide salts are used.

7. A process as claimed in any of claims 1 to 6, wherein carbonates, phosphates, borates, carboxylates, alkoxides and/or phenoxides which are soluble in the aprotic polar and/or protic polar solvents are used as basic salts.

## Revendications

1. Procédé de préparation d'un cliché en relief, dont la couche en relief, obtenue par photopolymérisation, présente une surface exempte d'adhésif, par
(1) exposition, pour former une image, d'une couche d'enregistrement (A) formant relief et photopolymérisable, qui contient
(a₁) au moins un liant polymère à groupes acide,
(a₂) au moins un monomère photopolymérisable non saturé oléfinique, compatible avec le liant polymère (a₁) à groupes acide, et
(a₃) au moins un initiateur de photopolymérisation,
(2) élimination par lavage (développement) avec un dissolvant-révélateur des zones non exposées et, de ce fait, n'ayant pas été photopolymérisées, de la couche d'enregistrement (A) formant relief et exposée pour former une image, et
(3) retraitement de la couche en relief photopolymérisée résultante avec une solution de retraitement,
caractérisé en ce que l'on utilise, pour l'étape de procédé (3), une solution de retraitement basique contenant, à titre de base, des hydroxydes métalliques et/ou des sels métalliques réagissant de façon basique.

2. Le procédé selon la revendication 1, caractérisé en ce que le liant polymère (a₁) à groupes acide contient des groupes carboxyle.

3. Le procédé selon la revendication 1 ou 2, caractérisé en ce que la solution de retraitement contient au moins un solvant et au moins un hydroxyde métallique et/ou un sel métallique réagissant de façon basique.

4. Le procédé selon l'une des revendications 1 à 3, caractérisé en ce que le solvant de retraitement contient au moins un agent tensio-actif.

5. Le procédé selon la revendication 3 ou 4, caractérisé en ce que l'on utilise un solvant aprotique polaire et/ou protique polaire.

6. Le procédé selon l'une des revendications 1 à 5, caractérisé en ce qu'on utilise des hydroxydes alcalins, alcalino-terreux, de scandium, d'yttrium, de lanthane et/ou de lanthanides et/ou des sels, réagissant de façon basique, alcalins, alcalino-terreux, de scandium, d'yttrium, de lanthane et/ou de lanthanides.

7. Le procédé selon l'une des revendications 1 à 6, caractérisé en ce qu'on utilise, comme sels réagissant de façon basique, des carbonates, des phosphates, des borates, des carboxylates, des alkoxides et/ou des phénoxides, solubles dans les solvants aprotiques polaires et/ou protiques polaires.
